# FASCICULE DE BREVET EUROPEEN

(11) **EP 1 054 446 B1**
(45) Date de publication et mention de la délivrance du brevet: **07.08.2002**
(21) Numéro de dépôt: 00410048.3
(22) Date de dépôt: 11.05.2000
(51) Int. Cl.: H01L 23/31, H01L 23/48, H01L 23/482, H01L 21/60, H01L 21/768

(54) **Procédé de mise en boîtier d'une puce semiconductrice**
Verfahren zur Häusung eines Halbleiterchips
Method of packaging semiconductor chip

(30) Priorité: 12.05.1999 FR 9906244
(43) Date de publication de la demande: 22.11.2000
(73) Titulaire: STMicroelectronics S.A., 92120 Montrouge (FR)
(72) Inventeur: Josse, Emile, 37000 Tours (FR)
(74) Mandataire: de Beaumont, Michel

(56) Documents cités:
- WO-A-98/33215
- US-A- 3 454 835
- US-A- 3 648 131

## Description

La présente invention concerne la mise en boîtier d'une puce en matériau semiconducteur, plus particulièrement, pour un montage sur une plaquette de circuit imprimé. L'invention s'applique à des composants pour lesquels il est nécessaire de prendre au moins un contact électrique sur la face arrière de la puce semiconductrice.

Pour suivre la tendance à la miniaturisation des produits électroniques, on cherche à réduire l'encombrement d'un composant dont une part non négligeable provient de son boîtier de protection. Cette tendance à la miniaturisation des boîtiers a conduit, pour les circuits intégrés, à chercher à supprimer les boîtiers basés sur une encapsulation, dans un matériau tel qu'une résine époxy, d'une puce rapportée sur une grille de connexion. Un exemple de technique connue consiste à enfermer la puce entre une plaque de silicium et une plaque de verre, et à graver la plaque de verre afin de réaliser des ouvertures permettant d'accéder à des contacts en face dite supérieure ou avant de la puce. Ce type de boîtier est connu sous la dénomination CSP et n'est actuellement utilisé que pour des circuits intégrés dans lesquels des contacts ne sont prévus qu'en face avant de la puce.

Il serait souhaitable de pouvoir profiter des progrès de miniaturisation des boîtiers, également pour des puces ayant des contacts sur les deux faces. Le brevet US 3 648 131 A décrit une puce, ainsi que son procédé de fabrication, ayant des contacts sur les deux faces, et où les plots de contact externes sont réalisés directement sur une face de la plaquette semiconductrice.

Ainsi, un objet de la présente invention est de proposer un nouveau procédé de mise en boîtier d'une puce semiconductrice ayant des contacts sur les deux faces, qui permette un report des contacts sur une seule face du boîtier tout en minimisant la surface de ce boîtier, et en assurant sa solidité mécanique.

L'invention vise également à proposer une solution qui permette d'obtenir un boîtier de faible hauteur.

L'invention vise également à proposer une solution qui puisse être mise en oeuvre aussi bien pour des composants discrets que pour des circuits intégrés.

Pour atteindre ces objets, la présente invention prévoit un procédé tel que définit par la revendication 1 de mise en boîtier d'une puce réalisée dans une plaquette semiconductrice et présentant des contacts électriques sur ses deux faces, comprenant les étapes consistant à prévoir, sur une première face de la plaquette, au moins une zone conductrice débordant par rapport à la périphérie de la puce à former ; coller une première plaque épaisse en un matériau électriquement isolant sur la première face ; graver la plaquette depuis sa deuxième face pour définir des puces ; déposer au moins une piste conductrice s'étendant depuis un contact de la deuxième face de la puce jusqu'à la zone conductrice ; recouvrir la deuxième face d'une deuxième plaque épaisse formant un capot rigide avec interposition d'un matériau isolant de comblement entre les première et deuxième plaques ; et graver la première plaque au moins au droit de la zone conductrice pour y déposer un matériau conducteur s'étendant, sous forme de piste, jusqu'à la surface libre de la première plaque.

Selon un mode de réalisation de la présente invention, le procédé comprend en outre une étape finale de découpe pour séparer les boîtiers.

Selon un mode de réalisation de la présente invention, la première plaque isolante est amincie avant d'être ouverte au droit de ladite zone conductrice.

Selon un mode de réalisation de la présente invention, la deuxième face de la plaquette est amincie avant l'étape de gravure de définition des puces.

Selon un mode de réalisation de la présente invention, l'épaisseur de la deuxième plaque de recouvrement est choisie en fonction de la tenue mécanique dont doit disposer le boîtier une fois terminé.

Selon un mode de réalisation de la présente invention, la gravure de la première plaque isolante est effectuée selon un motif de formation de deux plots par puce.

Selon un mode de réalisation de la présente invention, le report de contact depuis ladite zone conductrice s'effectue dans une zone de séparation des deux plots jusqu'à la surface libre d'un desdits plots.

Selon un mode de réalisation de la présente invention, la deuxième plaque est en un matériau électriquement isolant.

Selon un mode de réalisation de la présente invention, la deuxième plaque est, au moins partiellement, en un matériau thermiquement conducteur.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue partielle en coupe très schématique d'un exemple de composant semiconducteur auquel s'applique le procédé de mise en boîtier de l'invention ;
la figure 2 représente le composant de la figure 1 à l'issue d'une première étape du procédé de mise en boîtier selon l'invention ;
la figure 3 représente le composant de la figure 2 à l'issue d'une deuxième étape du procédé selon l'invention ;
la figure 4 représente le composant de la figure 3 à l'issue d'une troisième étape du procédé selon l'invention ;
les figures 5A et 5B représentent, respectivement en coupe et vu de dessous, le composant mis en boîtier ; et
les figures 6A et 6B représentent, de façon très schématique et, respectivement, en coupe et vu de dessous, un mode de réalisation de la présente invention appliquée à une puce de circuit intégré.

Les mêmes éléments ont été désignés par les mêmes références aux différentes figures. Pour des raisons de clarté, les représentations des figures ne sont pas à l'échelle et seuls les éléments nécessaires à la compréhension de l'invention ont été représentés aux figures et seront décrits par la suite.

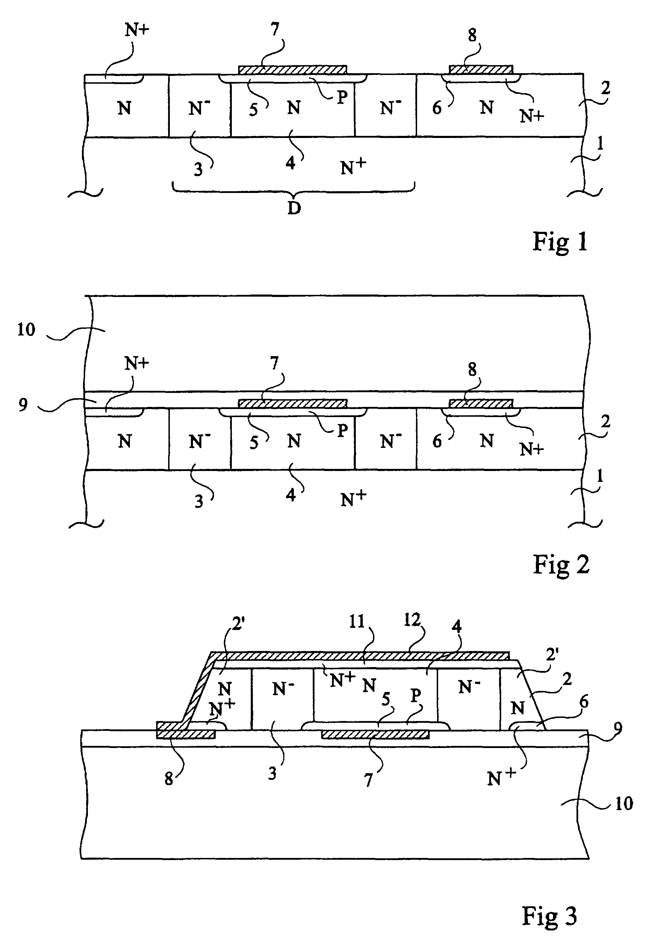

La figure 1 représente un exemple de composant semiconducteur auquel peut s'appliquer le procédé de l'invention. La représentation de la figure 1 correspond à une vue partielle en coupe d'une tranche de silicium, après que les différentes étapes de dopage aient été réalisées.

La figure 1 représente une diode Zener. Sur un substrat de silicium 1, dopé N⁺, on a réalisé une couche épitaxiée 2 dopée N. Une région en anneau 3 dopée N⁻ s'étend sur toute l'épaisseur de la couche épitaxiée 2, et délimite une région centrale 4 de la couche 2. Une région 5 fortement dopée P est formée sur une faible épaisseur de la couche 2 dans la région 4 et se termine dans l'anneau 3. La jonction entre les régions 4 et 5 constitue la diode Zener dont la cathode correspond au substrat 1.

On prévoit généralement une région 6 dopée N⁺, en forme d'anneau entourant la structure, réalisée par implantation depuis la face avant de la plaquette. Cette région 6 optionnelle a pour rôle d'éviter une propagation latérale d'impuretés à partir de l'extérieur comme on le verra ci-après.

Dans une structure classique, une fois que toutes les implantations ont été ainsi réalisées, la face arrière de la plaquette de silicium est revêtue d'une métallisation de cathode.

Le procédé de l'invention est mis en oeuvre sur une plaquette entière avant découpe pour individualiser les différents composants.

Une couche métallique est formée sur la face avant et gravée pour former des métallisations 7 de contact d'anode et des métallisations 8 externes à l'anneau 3.

La figure 2 représente la structure, à l'issue d'une première étape de réalisation du boîtier selon l'invention.

Cette première étape consiste à appliquer, sur la face avant de la plaquette 1 et avec interposition d'une couche 9 de colle, une plaque 10 en un matériau électriquement isolant, par exemple en verre. La couche 9 a pour objet, non seulement de fixer la plaque 10, mais également d'absorber les aspérités de surface (en particulier, liées aux métallisations 7 et 8). L'épaisseur de la plaque 10 est choisie pour conférer une bonne tenue mécanique à la structure dans les étapes ultérieures du procédé. De préférence, l'épaisseur de cette plaque est de plusieurs centaines de micromètres, par exemple de 200 à 500 µm.

La figure 3 représente la structure de la figure 2 à l'issue d'une deuxième étape du procédé selon l'invention. A la figure 3, la structure est représentée retournée par rapport à la figure 2. Pour toute la deuxième étape de procédé, le support mécanique est constitué par la plaque 10. Cette deuxième étape du procédé de l'invention se divise en trois phases.

Dans une première phase, on rectifie la face arrière de la plaquette de silicium 1, par exemple par meulage, en laissant subsister une faible épaisseur 11 du substrat 1. L'épaisseur de la couche épitaxiée 2 qui n'est pas altérée est classiquement fonction des performances souhaitées pour le produit et est généralement de plusieurs dizaines de micromètres pour des composants de puissance verticaux, par exemple de 10 à 70 µm.

Dans une deuxième phase, la périphérie externe de la couche épitaxiée 2 est éliminée jusqu'à atteindre la plaque 10 pour obtenir des puces individuelles de contour souhaité. Dans l'exemple représenté, il subsiste une région 2' dopée N autour de l'anneau 3 dopé N⁻. De plus, le motif de gravure est tel que, d'un côté de la structure, la métallisation 8 est au moins partiellement découverte. La position des régions 6 aura été choisie pour que ces régions débouchent à la périphérie de la puce pour assurer leur fonction d'arrêt de propagation d'impuretés.

La délimitation des puces est de préférence effectuée par gravure de sorte que les faces latérales soient inclinées pour faciliter un dépôt métallique ultérieur.

Dans une troisième phase, on dépose une métallisation qui s'étend sur toute la face supérieure de la structure, comme l'illustre la figure 3. La métallisation est gravée pour laisser en place une zone 12 qui recouvre au moins partiellement la région 11 au droit de la jonction de la diode, une tranche de la couche épitaxiée 2 et la métallisation 8.

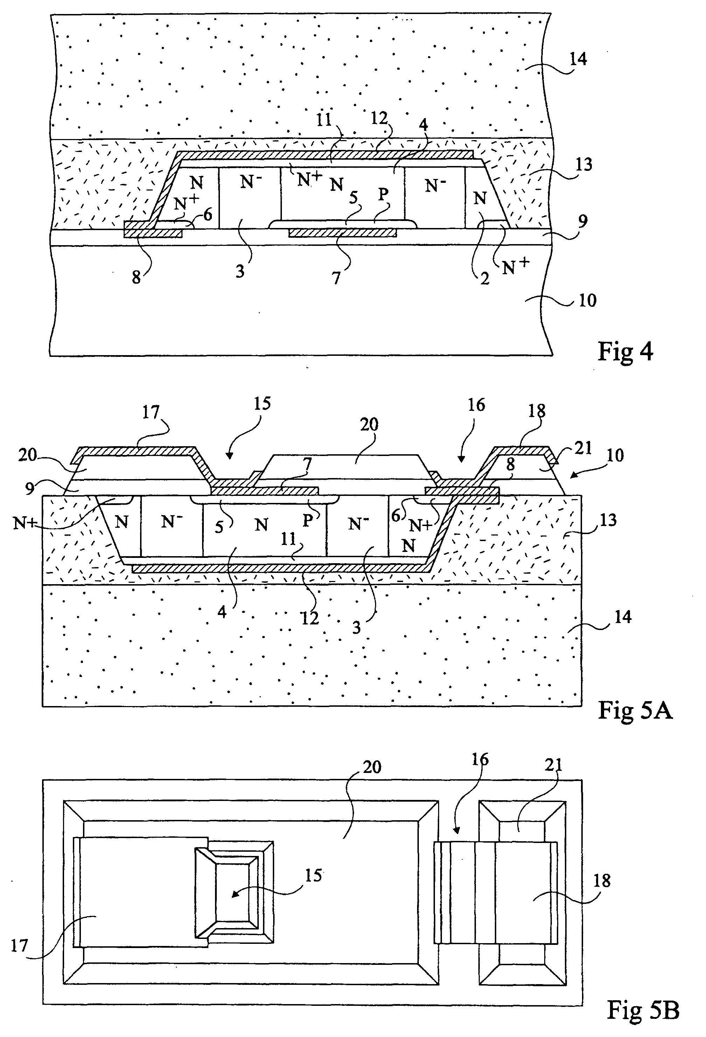

La figure 4 représente le composant de la figure 3 à l'issue d'une troisième étape du procédé de l'invention. Cette troisième étape comporte deux phases.

Dans une première phase, on recouvre l'ensemble de la structure d'un matériau d'encapsulation 13 de type résine époxy. L'épaisseur de la couche 13 est telle que la résine recouvre les zones 12 de métallisation en face arrière des composants. On veillera à ce que la résine se répartisse entre les différents composants portés par la plaque 10, c'est-à-dire dans toutes les tranchées réalisées dans la couche épitaxiée 2 et à ce que l'air soit éliminé de ces tranchées.

Dans une deuxième phase de la troisième étape illustrée par la figure 4, on recouvre l'ensemble de la structure d'une plaque 14 relativement épaisse, par exemple en silicium. L'épaisseur de la plaque 14 est choisie pour conférer au produit fini une résistance mécanique suffisante. En effet, selon la présente invention, la plaque 14 constitue, comme on le verra par la suite, le capot du boîtier. L'épaisseur de la plaque 14 est de plusieurs centaines de micromètres, par exemple comprise entre 200 et 800 µm.

On notera que d'autres matériaux que le silicium pourront être choisis pour réaliser la plaque de recouvrement ou capot 14. On pourra, par exemple, utiliser une deuxième plaque de verre, ou tout autre matériau propre à conférer au produit fini une rigidité mécanique suffisante pour une épaisseur la plus faible possible. Le silicium présente l'avantage de pouvoir être facilement découpé et de ne pas poser de problèmes de dilatation différentielle avec la puce.

Les figures 5A et 5B représentent, respectivement vu en coupe et vu de dessous, un composant semiconducteur en boîtier selon l'invention. Ces figures illustrent une quatrième étape du procédé de réalisation d'un boîtier selon l'invention. A la figure 5A, le composant a été représenté retourné par rapport aux figures 3 et 4, dans le même sens qu'en figures 1 et 2. Cette quatrième étape comporte deux phases.

Dans une première phase, l'épaisseur de la plaque 10 est réduite jusqu'à atteindre la valeur la plus faible possible tout en conférant au produit fini une protection suffisante, notamment d'isolement électrique. L'épaisseur de la plaque 10 pourra ainsi être ramenée à quelques dizaines de micromètres, par exemple une épaisseur comprise entre 10 et 50 µm. Le rôle final des zones de la plaque 10 qui subsistent est de former une couche d'isolement séparant les différents contacts électriques à reporter depuis le composant jusqu'à un circuit imprimé sur lequel il doit être monté.

La plaque isolante 10 est ensuite gravée localement à la périphérie des différents composants et pour définir au moins deux ouvertures 15, 16 d'accès aux métallisations 7 et 8.

Comme cela ressort plus particulièrement de la figure 5B, la gravure de la plaque 10 est de préférence réalisée de façon à laisser subsister pour chaque composant, deux plots isolants, respectivement 20 et 21. Le plot 20 recouvre sensiblement toute la surface du composant (ici, la diode D). L'ouverture 15 pratiquée dans le plot 20 permet la reprise du contact sur la métallisation 7. L'ouverture 16 permettant la reprise de contact sur la métallisation 8 a la forme d'une tranchée séparant le plot 20 du plot 21.

Dans une deuxième phase de la quatrième étape, on dépose une couche conductrice (par exemple, une couche d'or ou d'étain) qui se dépose également au fond des ouvertures 15 et 16 réalisées dans la plaque 10 pour contacter les métallisations 7 et 8. Cette couche en matériau conducteur est gravée selon un motif allant du fond des ouvertures 15 et 16 jusqu'à la surface libre des plots 20 et 21 pour former des contacts, respectivement 17 et 18, de raccordement du boîtier terminé.

Il ne reste plus, dans une cinquième étape, qu'à découper la plaque 14 pour individualiser les composants et obtenir un produit terminé tel qu'illustré en figures 5A et 5B. On notera qu'il ne subsiste pas de verre de la plaque 10 dans les chemins de découpe, celui-ci ayant été éliminé lors de la réalisation des plots 20 et 21. Ce composant en boîtier est prêt à être monté sur une carte de circuit imprimé, la partie supérieure de la figure 5A étant tournée vers des plages métallisées de la carte.

Un avantage de la présente invention est qu'elle permet des reprises de contact sans recourir à des fils de liaison qui nécessitent une encapsulation épaisse. Il en résulte que l'épaisseur du boîtier terminé est minimisée.

Un autre avantage de la présente invention est que l'encombrement en surface du composant en boîtier est très peu supérieur à la surface active.

Un autre avantage de la présente invention est que sa mise en oeuvre est compatible avec les procédés classiques de fabrication des composants semiconducteurs. En particulier, toutes les étapes du procédé de l'invention s'effectuent sur des plaquettes entières ce qui optimise le rendement.

Selon une variante de mise en oeuvre, on pourra prévoir de réduire l'épaisseur du capot de silicium 14 pour y associer une plaque métallique, relativement épaisse par rapport aux couches minces de métallisation, destinée à former un dissipateur thermique. Le maintien ou non d'une épaisseur de la plaque 14 dépend de l'application et, en particulier, du besoin d'isolement électrique éventuel entre le dissipateur thermique et la face arrière de la puce.

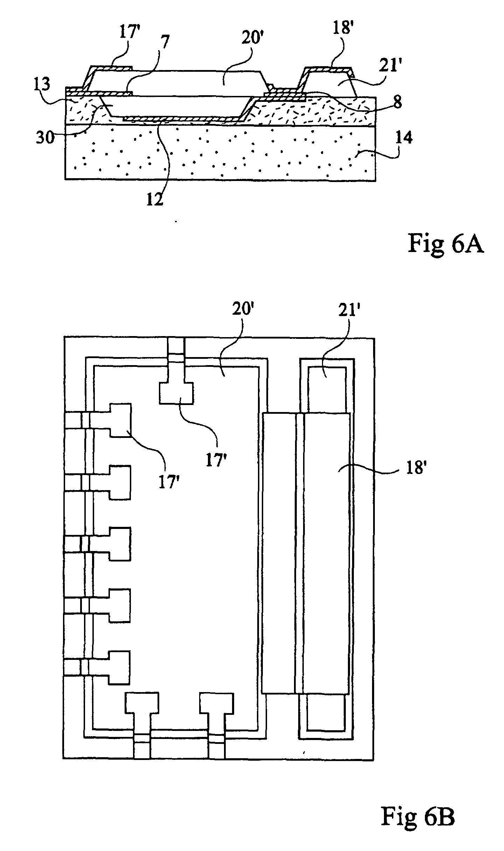

Les figures 6A et 6B illustrent de façon très schématique et, respectivement vu en coupe et vu de dessous, un circuit intégré mis en boîtier par le procédé selon l'invention.

L'application du procédé selon l'invention à une puce 30 de circuit intégré s'effectue de façon similaire au mode de mise en oeuvre exposé en relation avec les figures 1 à 5. Dans le cas d'un circuit intégré, l'invention s'applique plus particulièrement au cas où on a besoin de reprendre au moins un contact en face arrière du circuit intégré, par exemple, vers au moins une couche enterrée. Comme dans le premier mode de mise en oeuvre, la reprise de contact s'effectue au moyen d'une zone 12 gravée dans une couche de métallisation et contactant d'une part la face arrière de la puce 30 et, d'autre part, une zone 8 de métallisation déposée en même temps qu'une ou plusieurs zones 7 de prise de contact en face avant.

Comme dans le mode de mise en oeuvre précédent, l'isolement électrique des différents contacts est réalisé au moyen de deux plots 20' et 21', par exemple en verre. De même, la protection mécanique du circuit intégré est assurée par un capot 14, par exemple en silicium, sur la face arrière de la puce 30 avec interposition d'une couche de matériau d'encapsulation 13.

Une différence dans la mise en oeuvre du procédé de l'invention appliquée à un circuit intégré est que, pour contacter les métallisations 7 déposées sur des plots conducteurs de la puce 30, il n'est pas nécessaire de pratiquer des ouvertures dans le plot de verre 20'. On peut se contenter, comme l'illustre la figure 6A, de graver, dans la couche conductrice déposée sur les plots de verre 20' et 21', des pistes conductrices 17' rejoignant, par l'extérieur du plot 20', une extrémité laissée libre des zones 7. Côté reprise de contact de la face arrière 8, le report du contact vers le dessus du plot 21' s'effectue au moyen d'une piste 18' comme dans le mode de réalisation précédent.

Bien entendu, la présente invention est susceptible de diverses variantes et modifications qui apparaîtront à l'homme de l'art. En particulier, l'adaptation du procédé de l'invention à la mise en boîtier de composants semiconducteurs autres qu'une diode telle qu'illustrée par les figures 1 à 5 est à la portée de l'homme du métier à partir des indications fonctionnelles données ci-dessus. On notera que l'invention autorise la réalisation de plusieurs reports de contact depuis la face arrière. Il suffit pour cela de graver différemment la couche de métallisation servant à réaliser la zone 12, pour former plusieurs pistes reportées par les bords de la puce de silicium vers la face avant. En outre, les indications dimensionnelles données ci-dessus à titre d'exemple pourront être modifiées, en particulier, en fonction de la résistance mécanique souhaitée et de la surface de la puce, et en fonction des contraintes d'épaisseur liées, par exemple, à la tenue en tension du composant.

Il sera clair pour l'homme de l'art que la présente invention vise également un boîtier obtenu par le procédé revendiqué.

## Revendications

1. Procédé de mise en boîtier d'une puce réalisée dans une plaquette semiconductrice (1) et présentant des contacts électriques sur ses deux faces, comprenant les étapes suivantes :
prévoir, sur une première face de la plaquette, au moins une zone conductrice (8) débordant par rapport à la périphérie de la puce à former ;
coller une première plaque épaisse (10) en un matériau électriquement isolant sur la première face ;
graver la plaquette depuis sa deuxième face pour définir des puces de manière que la zone conductrice (8) soit au moins partiellement découverte;
déposer au moins une piste conductrice (12) s'étendant depuis un contact (11) de la deuxième face de la puce jusqu'à ladite zone conductrice (8);
recouvrir la deuxième face d'une deuxième plaque épaisse (14) formant un capot rigide avec interposition d'un matériau isolant de comblement (13) entre les première et deuxième plaques ; et
graver la première plaque au moins au droit de ladite zone conductrice (8) jusqu'à découvrir au moins partiellement cette zone pour y déposer un matériau conducteur s'étendant, sous forme de piste (18, 18'), jusqu'à la surface libre de la première plaque.

2. Procédé selon la revendication 1, **caractérisé en ce qu'**il comprend en outre une étape finale de découpe pour individualiser les composants.

3. Procédé selon la revendication 1 ou 2, **caractérisé en ce que** la première plaque isolante (10) est amincie avant d'être ouverte au droit de ladite zone conductrice (8).

4. Procédé selon l'une quelconque des revendications 1 à 3, **caractérisé en ce que** la deuxième face de la plaquette (1) est amincie avant l'étape de gravure de définition des puces.

5. Procédé selon l'une quelconque des revendications 1 à 4, **caractérisé en ce que** la gravure de la première plaque isolante (10) est effectuée selon un motif de formation de deux plots (20, 21 ; 20', 21') par puce.

6. Procédé selon la revendication 5, **caractérisé en ce que** le report de contact depuis ladite zone conductrice (8) s'effectue dans une zone (16) de séparation des deux plots jusqu'à la surface libre d'un des plots (21, 21').

7. Procédé selon l'une quelconque des revendications 1 à 6, **caractérisé en ce que** la deuxième plaque (14) est en un matériau électriquement isolant.

8. Procédé selon l'une quelconque des revendications 1 à 7, **caractérisé en ce que** la deuxième plaque (14) est, au moins partiellement, en un matériau thermiquement conducteur.

## Patentansprüche

1. Verfahren zum Packen eines Chips ausgebildet in einem Halbleiterwafer (1) und mit elektrischen Kontakten an seinen beiden Oberflächen, wobei die folgenden Schritte vorgesehen sind:
Vorsehen auf einer ersten Oberfläche des Wafers von mindestens einem leitenden Gebiet oder einer leitenden Fläche (8), die sich über den Umfang des zu formenden Chips hinaus erstreckt;
Kleben einer ersten dicken Platte (10) aus einem elektrischen Isoliermaterial an die erste Oberfläche;
Ätzen des Wafers von seiner zweiten Oberfläche zum Definieren der Chips, so daß die leitende Fläche bzw. leitende Gebiet (8) mindestens teilweise freigelegt ist;
Abscheiden von mindestens einer leitenden Spur oder Bahn (12), die sich von einem Kontakt (11) der zweiten Chipoberfläche zu der leitenden Fläche (8) erstreckt;
Abdecken der zweiten Oberfläche mit einer zweiten dicken Platte (14), die eine starre Kappe bildet und zwar mit einem dazwischen liegenden Isolierfüllmaterial (13) zwischen den ersten und zweiten Platten; und
Ätzen der ersten Platte mindestens oberhalb der leitenden Schicht (8) bis dieses Gebiet mindestens partiell freigelegt ist, um darauf ein leitendes Material abzuscheiden und zwar sich in der Form einer Spur oder Bahn (18, 18') zu der freilegenden Oberfläche der Platte erstrecken.

2. Verfahren nach Anspruch 1, **dadurch gekennzeichnet, daß** es ferner einen Endschneidschritt aufweist, um die Komponenten zu individualisieren.

3. Verfahren nach Anspruch 1 oder 2, **dadurch gekennzeichnet, daß** die erste Isolierplatte (10) verdünnt wird, bevor sie oberhalb der leitenden Fläche (8) geöffnet wird.

4. Verfahren nach einem der Ansprüche 1 bis 3, **dadurch gekennzeichnet, daß** die zweite Oberfläche des Wafers (1) verdünnt wird, bevor der Schritt des Chipdefinitionsätzens ausgeführt wird.

5. Verfahren nach einem der Ansprüche 1 bis 4, **dadurch gekennzeichnet, daß** das Ätzen der ersten lsolierplatte (10) entsprechend einem Formungsmuster von zwei Anschlüssen (Pads) (20, 21; 20', 21') pro Chip ausgeführt wird.

6. Verfahren nach Anspruch 5, **dadurch gekennzeichnet, daß** die Kontaktübertragung von dem leitenden Gebiet bzw. leitenden Fläche (8) in einem gesonderten Gebiet oder gesonderten Fläche (16) der zwei Anschlüsse zu der freiliegenden Oberfläche eines der Anschlüsse (20, 21') ausgeführt wird.

7. Verfahren nach einem der Ansprüche 1 bis 6, **dadurch gekennzeichnet, daß** die zweite Platte (14) aus einem elektrischen lsoliermaterial hergestellt ist.

8. Verfahren nach einem der Ansprüche 1 bis 7, **dadurch gekennzeichnet, daß** die zweite Platte (14) mindestens teilweise aus einem thermisch leitenden Material hergestellt ist.

## Claims

1. A method for packaging a chip formed in a semiconductor wafer (1) and having electric contacts on both its surfaces, including the steps of:
providing, on a first surface of the wafer, at least one conductive area (8) extending beyond the periphery of the chip to be formed;
gluing a first thick plate (10) made of an electrically isolating material on the first surface;
etching the wafer from its second surface to define chips, so that the conductive area (8) is at least partially exposed;
depositing at least one conductive track (12) extending from a contact (11) of the second chip surface to said conductive area (8);
covering the second surface with a second thick plate (14) forming a rigid cap with an interposed isolating filling material (13) between the first and second plates; and
etching the first plate at least above the conductive layer (8) until at least partially exposing this area to deposit thereon a conductive material extending, in the form of a track (18, 18'), to the exposed surface of the first plate.

2. The method of claim 1, **characterized in that** it further includes a final cutting step to individualize the components.

3. The method of claim 1 or 2, **characterized in that** the first isolating plate (10) is thinned before being opened above the conductive area (8).

4. The method of any of claims 1 to 3, **characterized in that** the second surface of the wafer (1) is thinned before the step of chip definition etching.

5. The method of any of claims 1 to 4, **characterized in that** the etching of the first isolating plate (10) is performed according to a pattern of formation of two pads (20, 21; 20', 21') per chip.

6. The method of claim 5, **characterized in that** the contact transfer from the conductive area (8) is performed in a separation area (16) of the two pads, to the exposed surface of one of the pads (20, 21').

7. The method of any of claims 1 to 6, **characterized in that** the second plate (14) is made of an electrically isolating material.

8. The method of any of claims 1 to 7, **characterized in that** the second plate (14) is, at least partially, made of a thermally conductive material.
